Europäisches Patentamt

European Patent Office

Office européen des brevets

(19)

(11) Veröffentlichungsnummer: **0 085 830**

**A2**

(12) # EUROPÄISCHE PATENTANMELDUNG

(21) Anmeldenummer: 83100146.6

(22) Anmeldetag: 10.01.83

(51) Int. Cl.³: **H 03 H 11/12**

(30) Priorität: 10.02.82 DE 3204508
07.04.82 DE 3213098

(43) Veröffentlichungstag der Anmeldung:
17.08.83 Patentblatt 83/33

(84) Benannte Vertragsstaaten:
AT BE CH DE FR GB IT LI LU NL SE

(71) Anmelder: thielscher-electronic GmbH
Falkstrasse 71-77
D-4100 Duisburg 1(DE)

(72) Erfinder: Benzinger, Hans, Dr.-Ing. Dipl.-Phys.
Allgäuer Strasse 99
D-4100 Duisburg 29(DE)

(74) Vertreter: Gesthuysen, Hans Dieter, Dipl.-Ing. et al,
Patentanwälte Gesthuysen + von Rohr Huyssenallee 15
Postfach 10 13 33
D-4300 Essen 1(DE)

(54) Koppelfilter, insbesondere Eingangsfilter für Empfänger von Rundsteueranlagen.

(57) Dargestellt und beschrieben ist ein Koppelfilter, insbesondere ein Eingangsfilter für Empfänger von Rundsteueranlagen, mit einer Mehrzahl von gleichartigen Vierpolen, wobei jeweils benachbarte Vierpole über Kopplungsadmittanzen miteinander gekoppelt sind. Insbesondere beschrieben ist ein RC-Koppelfilter mit aktiven RC-Vierpolen, bei dem jeder aktive RC-Vierpol ($2_m$) eine Ableitadmittanz (3), zwei Filteradmittanzen (4, 5), eine Rückführadmittanz (6) und einen Verstärker (7) aufweist, die Ableitadmittanz (3) und die Filteradmittanzen (4, 5) jeweils mit einem Ende miteinander und mit dem Eingang (8) des RC-Vierpoles ($2_m$) verbunden sind, die Rückführadmittanz (6) mit einem Ende mit dem anderen Ende der ersten Filteradmittanz (4) und dem Eingang (9) des Verstärkers (7) verbunden ist und die anderen Enden der zweiten Filteradmittanz (5) und der Rückführadmittanz (6) sowie der Ausgang (10) des Verstärkers (7) miteinander und mit dem Ausgang (11) des RC-Vierpoles ($2_m$) verbunden sind und bei dem, bis auf den ersten RC-Vierpol und den letzten RC-Vierpol, der Eingang (8) jedes RC-Vierpoles ($2_m$) einer seits über eine Kopplungsadmittanz ($14_{m-1}$) mit dem Ausgang (11) des vorhergehenden RC-Vierpoles und andererseits über eine weitere Kopplungsadmittanz ($15_m$) mit dem Ausgang (11) des nachfolgenden RC-Vierpoles verbunden. Auch ist der Ausgang (11) jedes RC-Vierpoles ($2_m$) einerseits über eine Kopplungsadmittanz ($15_{m-1}$) mit dem Eingang (8) des vorhergehenden RC-Vierpoles und andererseits über eine weitere Kopplungsadmittanz ($14_m$) mit dem Eingang (8) des nachfolgenden RC-Vierpoles verbunden. Auch ein entsprechendes LC-Koppelfilter ist beschrieben. Diese Koppelfilter zeichnen sich durch eine besonders hohe Stabilität bei bestmöglicher Selektivität und kürzesten Einschwingzeiten aus.

EP 0 085 830 A2

Die Erfindung betrifft ein Koppelfilter, insbesondere ein Eingangsfilter für Empfänger von Rundsteueranlagen, mit einer Mehrzahl von gleichartigen Vierpolen,wobei jeweils benachbarte Vierpole über jeweils zwei Kopplungsadmittanzen miteinander gekoppelt sind.

Filter kann man u. a. nach folgenden Kriterien unterscheiden:

a) Nach der Art der die Frequenz bestimmenden Bauteile; handelt es sich bei den die Frequenz bestimmenden Bauteilen um Spulen und Kondensatoren, so liegen LC-Filter vor, werden als die Frequenz bestimmende Bauteile Widerstände und Kondensatoren verwendet, so erhält man RC-Filter.

b) Nach der Art der Realisierung des Koppelfaktors; ist der Koppelfaktor durch das Verhältnis substantiell oder gegenständlich vorhandener Kopplungsbauelemente gegeben, so spricht man von einem Koppelfilter, ist der Koppelfaktor nicht durch das Verhältnis substantiell oder gegenständlich vorhandener Kopplungsbauelemente gegeben, so spricht man von einem Verstimmungsfilter.

c) Danach, ob zu den verwendeten Vierpolen aktive Bauelemente gehören oder nicht; man spricht von aktiven bzw. passiven Filtern.

Ausgangspunkt der Erfindung ist zunächst ein bekanntes RC-Koppelfilter in Form eines Bandfilters (vgl. die DE-AS 24 36 966). Bei diesem bekannten RC-Koppelfilter handelt es sich um ein zweikreisiges aktives Filter, das eine Vielzahl von Vorteilen aufweist; u. a.:

a) Die Dämpfungen d sind als reine Widerstands- und Kapazitätsverhältnisse hervorragend konstant, so daß jegliche Temperaturkompensation entfällt.

b) Man kann jede beliebige Dämpfung d realisieren. Damit kann man das bekannte aktive RC-Bandfilter an alle praktischen Forderungen anpassen, z. B. schmal- oder breitbandig bzw. langsam oder schnell einschwingend ausführen.

c) Die Auskopplungslast hat keinen Einfluß auf die Selektivität, weil der Verstärker des letzten RC-Vierpoles die Leistung liefert und jede Rückwirkung unterbindet; zusätzliche Leistungsverstärker werden also nicht benötigt.

d) Durch den Verstärker des letzten RC-Vierpoles sind stets große Ausgangspegel möglich. Dadurch werden Schwellwerte, z. B. von Transistoren, bedeutungslos, und man erreicht eine echte Schalterfunktion.

e) Man kann stets optimal (=kritisch) koppeln, so daß man relativ große Dämpfungen d und folglich kurze Einschwingzeiten (und damit verbundene geringe Impulsverzerrungen) bekommt.

f) Der Koppelfaktor k und damit der Verstärkungsfaktor v ist weitgehend stabil, da der Koppelfaktor k nur durch zwei gleichartige (kapazitive oder ohm'sche) Kopplungsadmittanzen bestimmt ist.

Wenn auch mit dem bekannten zweikreisigen RC-Koppelfilter schon ausgezeichnete Ergebnisse erzielt worden sind, so hat man gleichwohl schon erwogen, durch Hintereinanderschaltung mehrerer derartiger zweikreisiger RC-Koppelfilter noch weiter verbesserte Eigenschaften zu erzielen, insbesondere eine gegenüber einem zweikreisigen RC-Koppelfilter verbesserte Einschwingzeit (vgl. wiederum die DE-AS 24 36 966). Bei derartigen Hintereinanderschaltungen (Kettenschaltungen) zweikreisiger RC-Koppelfilter ergibt sich allerdings das Problem, daß die Koppelfaktoren zwischen den einzelnen zweikreisigen RC-Koppelfiltern nicht durch das Verhältnis substantiell oder ge-

genständlich vorhandener Kopplungsbauelemente gegeben sind. Die bei einem zweikreisigen RC-Koppelfilter eliminierten Probleme hinsichtlich der Koppelfaktoren treten also bei derartigen Kettenschaltungen in gewissem Umfange wieder auf, da die Verstimmungs-Koppelfaktoren zwischen den einzelnen Kettengliedern als kleine Differenz großer Frequenzen gegenüber Elementevariationen sehr empfindlich sind.

Außerdem sind natürlich aktive RC-Vierpole unterschiedlichster Ausgestaltung, nämlich als Tiefpaßfilter, Hochpaßfilter, Bandpaßfilter (Bandfilter, selektive Filter), Sperrfilter, Notchfilter, Allpaßfilter usw., bekannt (vgl. Tietze, Schenk "Halbleiter-Schaltungstechnik", 3. Auflage 1974, Kapitel 11, Seite 306 ff.).

Im übrigen sind, wie eingangs schon kurz erläutert worden ist, auch LC-Koppelfilter bekannt, und zwar unter anderem ein zweikreisiges LC-Koppelfilter mit passiven LC-Vierpolen (vgl. die DE-AS 19 14 893). Bei diesem zweikreisigen LC-Koppelfilter wird die Kopplungsenergie zwischen den beiden Kreisen über ein und dasselbe Kopplungselement hin und her ausgetauscht, nämlich über die unvermeidbar vorhandene Gegeninduktivität. Im übrigen sind mehrkreisige LC-Koppelfilter als Hochfrequenzbandfilter bekannt, die aus gekoppelten, passiven LC-Zweipolen bestehen (vgl. E. Philippow "Taschenbuch Elektrotechnik" Band 2: "Informatik", Carl Hanser Verlag München, Wien, 1977, Seite 556). Die einzelnen LC-Zweipole bei diesem bekannten LC-Koppelfilter können als Parallelkreise bzw., bei entsprechender Umrechnung, auch als Serienkreise ausgeführt werden.

Ausgehend von dem zuvor erläuterten Stand der Technik liegt der Erfindung nun die Aufgabe zugrunde, ein mehrkreisiges (n-kreisiges) Koppelfilter anzugeben, bei dem eine bestmögliche Selektivität und kürzeste Einschwingzeiten mit einer hohen Stabilität (Unempfindlichkeit gegen Variationen der verwendeten Koppelbauelemente) verbunden sind.

Der erfindungsgemäße Koppelfilter, bei dem die zuvor aufgezeigte Aufgabe gelöst ist,ist in einer ersten Version dadurch gekennzeichnet, daß als Vierpole aktive RC-Vierpole vorgesehen sind, daß vorzugsweise jeder aktive RC-Vierpol eine Ableitadmittanz, zwei Filteradmittanzen, eine Rückführadmittanz und einen Verstärker aufweist, die Ableitadmittanz und die Filteradmittanzen jeweils mit einem Ende miteinander und mit dem Eingang des RC-Vierpoles verbunden sind, die Rückführadmittanz mit einem Ende mit dem anderen Ende der ersten Filteradmittanz und dem Eingang des Verstärkers verbunden ist und die anderen Enden der zweiten Filteradmittanz und der Rückführadmittanz sowie der Ausgang des Verstärkers miteinander und mit dem Ausgang des RC-Vierpoles verbunden sind und daß bis auf den ersten RC-Vierpol und den letzten RC-Vierpol, der Eingang jedes RC-Vierpoles einerseits über eine Kopplungsadmittanz mit dem Ausgang des vorhergehenden RC-Vierpoles und andererseits über eine weitere Kopplungsadmittanz mit dem Ausgang des nachfolgenden RC-Vierpoles verbunden ist und der Ausgang jedes RC-Vierpoles einerseits über eine Kopplungsadmittanz mit dem Eingang des vorhergehenden RC-Vierpoles und andererseits über eine weitere Kopplungsadmittanz mit dem Eingang des nachfolgenden RC-Vierpoles verbunden ist.

Wenn hier und im folgenden vom Eingang des Verstärkers die Rede ist, so ist damit ohne ausdrücklichen gegenteiligen Hinweis der invertierende Eingang des Verstärkers gemeint. Ohne ausdrücklichen gegenteiligen Hinweis liegt in einem solchen Fall der nichtinvertierende Eingang des Verstärkers an Masse.

Wesentlich für das erfindungsgemäße mehrkreisige RC-Koppelfilter ist, daß die n RC-Vierpole eine durchgehende Kette bilden und über verschachtelte Rückkopplungen miteinander verbunden sind. Aus den Merkmalen des kennzeichnenden Teiles des Patentanspruches 1 ergibt sich im übrigen implizit, wie die Verbindung des ersten und des letzten RC-Vierpoles aussehen müssen, daß nämlich der Ausgang des ersten RC-Vierpoles über eine Kopplungsadmittanz mit dem Eingang des zweiten RC-Vierpoles und der Eingang des ersten RC-Vierpoles über eine weitere Kopplungsadmittanz mit dem Ausgang des zweiten RC-Vierpoles verbunden ist, und daß der Ausgang des letzten RC-Vierpoles über eine Kopplungsadmittanz mit dem Eingang des vorletzten RC-Vierpoles und der Eingang des letzten RC-Vierpoles über eine weitere Kopplungsadmittanz mit dem Ausgang des vorletzten RC-Vierpoles verbunden ist.

Bei dem zuvor erläuterten erfindungsgemäßen Koppelfilter lassen sich praktisch alle Arten von RC-Vierpolen, wie sie zuvor erläutert worden sind, verwenden. Die Art der verwendeten RC-Vierpole definiert dann den Charakter des gesamten RC-Koppelfilters. Dabei ist das erfindungsgemäße RC-Koppelfilter hinsichtlich der Stabilität dem bekannten zweikreisigen RC-Bandfilter der eingangs erläuterten Art absolut gleichwertig, da sich sämtliche Koppelfaktoren als Quotienten gleichartiger Koppelbauelemente darstellen, so daß Variationen der verwendeten Koppelbauelemente praktisch keinen Einfluß auf die Koppelfaktoren haben. Von besonderer Bedeutung ist es, daß die Kopplungsadmittanzen durchweg durch passive Koppelbauelemente, nämlich durch Koppelwiderstände oder durch Koppelkondensatoren, verwirklicht werden können.

Die Einspeisung des zu filternden Signales erfolgt am ersten RC-Vierpol, während die Auskopplung des gefilterten Signales am letzten RC-Vierpol erfolgt. Für die Einspeisungsschaltungen, vielfach mit einem Einspeisungsstromwandler, gelten die gleichen Alternativen wie für die Einspeisungsschaltungen für das bekannte zweikreisige RC-Koppelfilter. Vielfach wird das zu filternde Signal direkt in den invertierenden Eingang des Verstärkers des ersten RC-Vierpoles eingespeist. Von besonderem Vorteil ist es aber, wenn die Einspeisung des zu filternden Signales in den nichtinvertierenden Eingang des Verstärkers des ersten RC-Vierpoles erfolgt. Hierdurch ist gewährleistet, daß die Symmetrie der RC-Vierpole durch die Einspeisung nicht gestört wird.

Zuvor ist schon erläutert worden, daß die Admittanzen generell als Widerstände oder als Kondensatoren realisierbar sind. Je nachdem, welche Filtercharakteristik man zu erzielen wünscht, kann man die entsprechenden Admittanzen als ohm'sche Widerstände oder als Kondensatoren realisieren. Sind
beispielsweise zur Ausbildung als Bandpaß in jedem RC-Vierpol die Ableitadmittanz und die Rückführadmittanz jeweils als ohm'scher Widerstand und
die Filteradmittanzen als Kondensatoren realisiert, so sollten zweckmäßigerweise die Kopplungsadmittanzen als Kondensatoren realisiert sein. Diese
Ausgestaltung ist von besonderem Vorteil, da das erfindungsgemäße RC-Koppelfilter insgesamt besonders geeignet zur Realisierung extrem schmalbandiger
Bandpässe ist.

Ist das erfindungsgemäße RC-Koppelfilter als Bandpaßfilter ausgestaltet, so
läßt es sich als reell abgeschlossener Reaktanz-Vierpol behandeln, sofern
die RC-Vierpole außer dem ersten RC-Vierpol und außer dem letzten RC-Vierpol vollständig entdämpft sind. Eine solche Entdämpfung der "inneren" RC-
Vierpole läßt sich dadurch realisieren, daß, bis auf den ersten RC-Vierpol
und den letzten RC-Vierpol, der nichtinvertierende Eingang des Verstärkers
jedes RC-Vierpoles über eine erste Abstimmadmittanz mit dem Ausgang des
Verstärkers und über eine zweite Abstimmadmittanz mit Masse verbunden ist.
Vorzugsweise sind die Abstimmadmittanzen dabei als ohm'sche Widerstände realisiert. Die Abstimmadmittanzen lassen sich hierbei so einstellen, daß die
inneren Dämpfungen der entsprechenden RC-Vierpole praktisch vernachlässigbar klein werden. Die "inneren" RC-Vierpole sind also praktisch vollständig entdämpft, so daß die Anzahl der Poldämpfungen auf zwei gesenkt werden
kann. Dadurch wird das RC-Koppelfilter als schmalbandiges Bandpaßfilter
erheblich stabiler als jede andere vergleichbare Schaltung.

Alternativ zu der zuvor erläuterten Ausführungsform mit entsprechenden Abstimmadmittanzen in den "inneren" RC-Vierpolen läßt sich auch dann ein reell abgeschlossener Reaktanz-Vierpol realisieren, wenn jeder der RC-Vierpole als Resonator mit zwei mit ihren invertierenden Eingängen miteinander verbundenen Verstärkern ausgebildet ist. Derartige Resonatoren sind als solche bekannt. Sie arbeiten extrem verlustarm, haben also eine äußerst geringe Dämpfung bei der entsprechenden Frequenz. Außerdem sind derartige Resonatoren noch unempfindlicher gegen Elementevariationen, also noch stabiler, da sie wegen der beiden Verstärker eine sehr hohe Leerlaufverstärkung haben.

Weitere Schaltungsmöglichkeiten ergeben sich, wenn man jeden RC-Vierpol als mehrstufige Universalschaltung, vorzugsweise mit Summierstufe, zwei Integrierstufen und Invertierstufe ausbildet. Eine solche mehrstufige Universalschaltung hat den Vorteil, daß die möglichen Eingänge und Ausgänge von vornherein schon vorgegeben sind. Durch Wahl unterschiedlicher Eingänge bzw. Ausgänge lassen sich unterschiedliche Filtercharakteristika verwirklichen. Derartige Universalschaltungen sind beispielsweise als in CMOS-Technologie integrierte Kondensatorenschalterfilter bekannt. Derartige Kondensatorschalterfilter weisen einen taktenden Schwingquarz auf, sind also in höchstem Maße frequenzkonstant. Gerade mit diesen Filtern ist die vorteilhafte Gestaltung des erfindungsgemäßen RC-Koppelfilters mit dem hochstabilen Koppelfaktoren optimal ausnutzbar.

Abschließend bleibt noch darauf hinzuweisen, daß je nach Auslegung mit dem erfindungsgemäßen mehrkreisigen RC-Koppelfilter natürlich auch alle speziellen Arten von Filtern, beispielsweise Bessel-Filter, Butterworth-Filter, Tschebyscheff-Filter usw., bei entsprechender Einstellung der einzelnen Admittanzen verwirklicht werden können.

Die zuvor aufgezeigte Aufgabe ist im übrigen in einer zweiten Version durch ein Koppelfilter gelöst, das dadurch gekennzeichnet ist, daß als Vierpole

aktive LC-Vierpole vorgesehən sind, daß jeder aktive LC-Vierpol mindestens
eine Filterinduktivität, eine Filterkapazität und einen Verstärker aufweist.
und daß jeweils benachbarte LC-Vierpole über die Filterinduktivitäten induktiv miteinander gekoppelt sind. Die in dieser Version des erfindungsgemäßen Koppelfilters vorgesehenen aktiven LC-Vierpole sind den RC-Vierpolen
der zuvor erläuterten Version eines Koppelfilters entsprechend ausgestaltet.
Diese LC-Vierpole können als Serienkreise oder als Parallelkreise ausgestaltet sein, was im einzelneň der Erläuterung nicht bedarf. Die Kopplung
benachbarter LC-Vierpole miteinander erfolgt über die jeweiligen Filterinduktivitäten bzw. die entsprechenden Gegeninduktivitäten, wie das an sich
bei passiven LC-Koppelfiltern bekannt ist.

Nachdem zuvor das mehrkreisige RC-Koppelfilter so ausführlich erläutert
worden ist, bedarf das äquivalente LC-Koppelfilter nur noch einer kurzen
Erläuterung.

Zunächst sind, neben dem zwingend vorhandenen, der Filterinduktivität zugeordneten ohm'schen Widerstand zweckmäßigerweise ein Ableitwiderstand und
ein Filterwiderstand in jedem LC-Vierpol vorgesehen. Der Ableitwiderstand
ist dabei zweckmäßigerweise als bifilarer Kupferwiderstand ausgeführt, während der Filterwiderstand vorzugsweise als Metallschichtwiderstand ausgeführt sein sollte. Dadurch werden Temperatureinflüsse vermieden.

In gleicher Weise, wie das zuvor schon bei den RC-Vierpolen des zuvor erläuterten RC-Koppelfilters angegeben worden ist, kann auch bei jedem der
LC-Vierpole des hier erläuterten LC-Koppelfilters der invertierende Eingang des Verstärkers über einen ersten Abstimmwiderstand mit dem Ausgang
des Verstärkers und über einen zweiten Abstimmwiderstand mit Masse verbunden sein.

Hinsichtlich der Einspeisung eines zu filternden Signales empfiehlt es sich schließlich, dieses über die Filterinduktivität des ersten LC-Vierpoles einzuspeisen, während die Auskopplung des gefilterten Signales zweckmäßigerweise über die Filterkapazität des letzten LC-Vierpoles erfolgt.

Im folgenden wird die Erfindung anhand einer lediglich Ausführungsbeispiele darstellenden Zeichnung näher erläutert; es zeigt.

Fig. 1 ein Schaltbild eines bei einem erfindungsgemäßen Koppelfilter verwendeten RC-Vierpoles,

Fig. 2 ein Schaltbild eines erfindungsgemäßen mehrkreisigen Koppelfilters mit RC-Vierpolen,

Fig. 3 ein Schaltbild eines RC-Vierpoles gemäß Fig. 1 modifiziert u. a. für die Realisierung eines Bandpaßfilters,

Fig. 4 ein Schaltbild eines als Resonator ausgeführten RC-Vierpoles gemäß Fig. 1,

Fig. 5 ein Schaltbild einer Universalschaltung für einen RC-Vierpol gemäß Fig. 1

Fig. 6 ein Schaltbild einer speziellen Ausführungsform der Universalschaltung nach Fig. 5,

Fig. 7 ein Schaltbild eines bei einem erfindungsgemäßen Koppelfilter verwendeten LC-Vierpoles und

Fig. 8 ein Schaltbild eines erfindungsgemäßen mehrkreisigen Koppelfilters mit LC-Vierpolen.

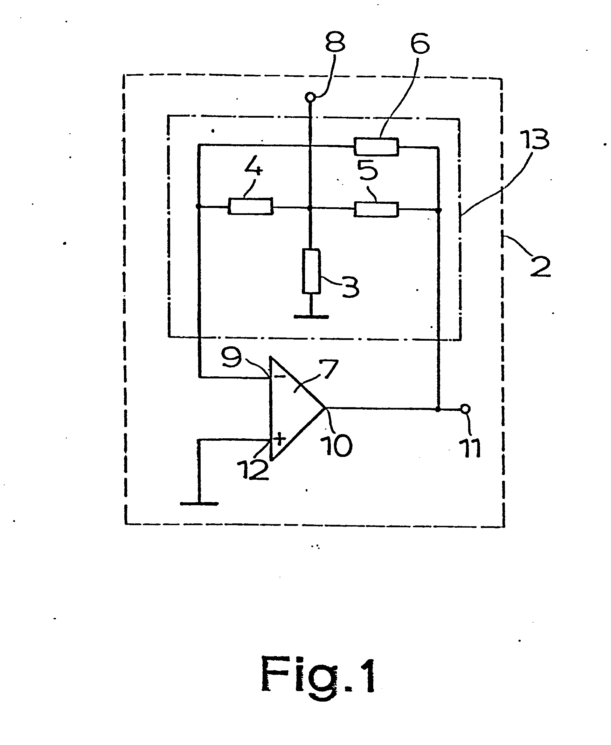

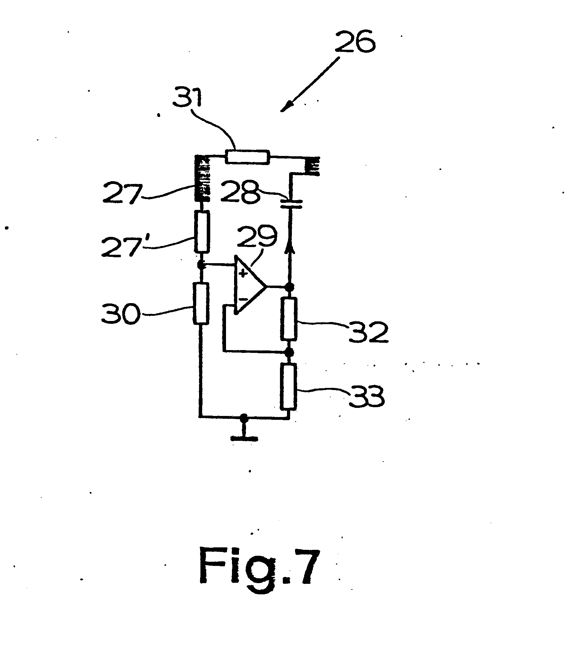

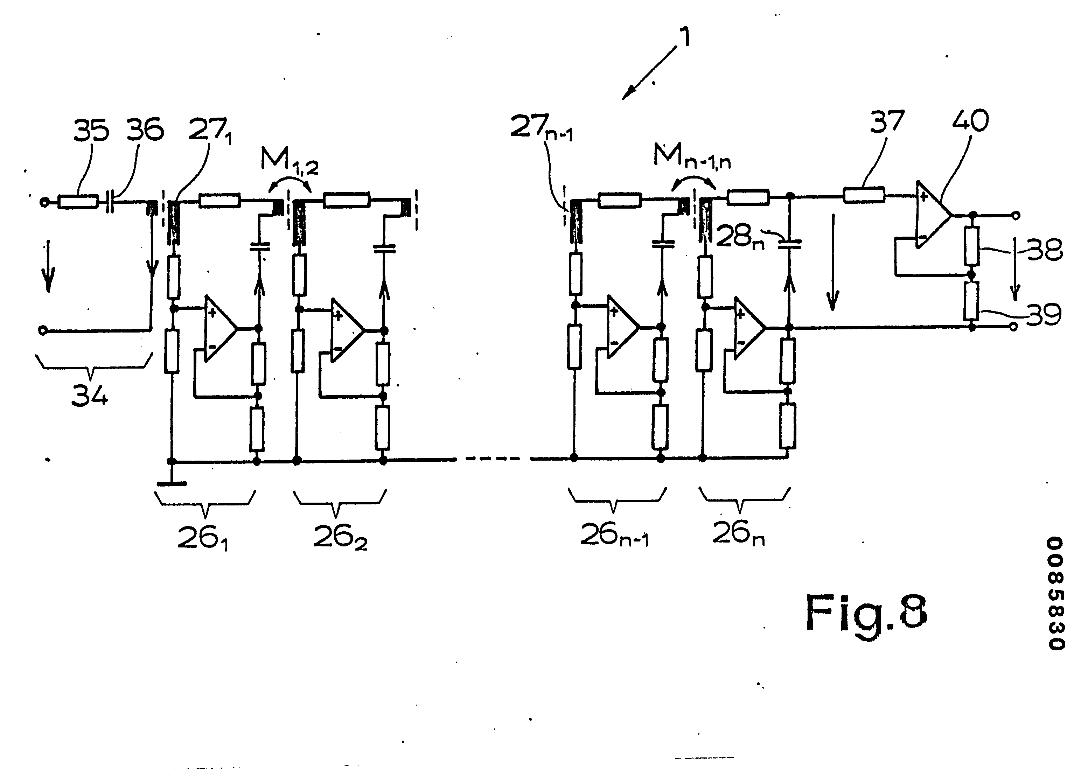

In den Figuren sind mehrkreisige, nämlich n-kreisige Koppelfilter 1 dargestellt, wobei die Fig. 1 bis 6 RC-Koppelfilter 1 betreffen, während die
Fig. 7 und 8 LC-Koppelfilter 1 betreffen.

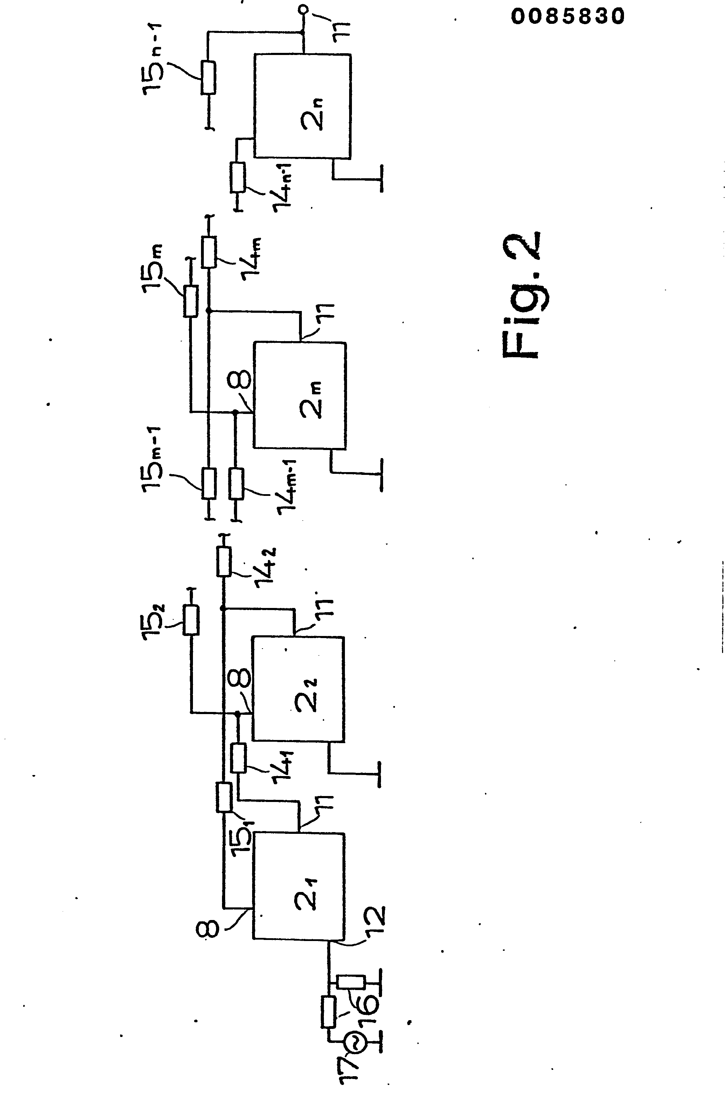

Das Koppelfilter 1 weist gemäß Fig. 2 eine Mehrzahl von gleichartigen aktiven RC-Vierpolen 2 auf. Ein solcher aktiver RC-Vierpol 2 ist in Fig. 1 dargestellt. Dieser RC-Vierpol 2 weist eine Ableitadmittanz 3, zwei Filteradmittanzen 4, 5, eine Rückführadmittanz 6 und einen Verstärker 7 auf. Die Ableitadmittanz 3 und die Filteradmittanzen 4, 5 sind jeweils mit einem Ende
miteinander und mit dem Eingang 8 des RC-Vierpoles 2 verbunden. Die Rückführadmittanz 6 ist mit einem Ende mit dem anderen Ende der ersten Filteradmittanz 4 und dem Eingang (dem invertierenden Eingang) 9 des Verstärkers 7
verbunden. Die anderen Enden der zweiten Filteradmittanz 5 und der Rückführadmittanz 6 sowie der Ausgang 10 des Verstärkers 7 sind miteinander und mit
dem Ausgang 11 des RC-Vierpoles 2 verbunden. Im dargestellten Ausführungsbeispiel ist im übrigen der nichtinvertierenden Eingang 12 des Verstärkers 7
an Masse gelegt. Die Ableitadmittanz 3, die Filteradmittanzen 4, 5 und die
Rückführadmittanz 6 bilden gemeinsam die Gegenkopplungsadmittanz 13.

n aktive RC-Vierpole 2 sind, wie Fig. 2 zeigt, zu einem RC-Koppelfilter 1
zusammengesetzt. Jeweils zwei aktive RC-Vierpole 2 sind dabei über jeweils
zwei Kopplungsadmittanzen 14, 15 miteinander gekoppelt. Im einzelnen ist,
bis auf den ersten RC-Vierpol $2_1$ und den letzten RC-Vierpol $2_n$, der Eingang 8 jedes RC-Vierpoles $2_m$ einerseits über eine Kopplungsadmittanz $14_{m-1}$
mit dem Ausgang 11 des vorhergehenden RC-Vierpoles $2_{m-1}$ und andererseits
über eine weitere Kopplungsadmittanz $15_m$ mit dem Ausgang 11 des nachfolgenden RC-Vierpoles $2_{m+1}$ verbunden und der Ausgang 11 jedes RC-Vierpoles $2_m$
einerseits über eine Kopplungsadmittanz $15_{m-1}$ mit dem Eingang 8 des vorhergehenden RC-Vierpoles $2_{m-1}$ und andererseits über eine weitere Kopplungsadmittanz $14_m$ mit dem Eingang 8 des nachfolgenden RC-Vierpoles $2_{m+1}$ verbunden. Dabei ist der erste RC-Vierpol $2_1$ natürlich nur mit dem zweiten

RC-Vierpol $2_2$ und der letzte RC-Vierpol $2_n$ natürlich nur mit dem vorletzten
RC-Vierpol $2_{n-1}$ verbunden. Der Index m steht im übrigen immer für eine der
Zahlen zwischen 1 und n, bezeichnet also stets einen "inneren" RC-Vierpol 2.

Die RC-Vierpole 2 bilden gewissermaßen eine durchgehende Kette mit verschachtelten Rückkopplungen über die Kopplungsadmittanzen 14 une 15. Ebenso wie
die Ableitadmittanz 3, die Filteradmittanzen 4, 5 und die Rückführadmittanz 6 jedes RC-Vierpoles 2 können auch die Kopplungsadmittanzen 14, 15
als Widerstände oder als Kondensatoren realisiert werden.

Wie Fig. 2 deutlich zeigt, erfolgt bei dem hier dargestellten Ausführungsbeispiel eines RC-Koppelfilters 1 die Einspeisung des zu filternden Signales
in den nichtinvertierenden Eingang 12 des Verstärkers 7 des ersten RC-Vierpoles $2_1$, und zwar über den Eingangsspannungsteiler 16 vermittels einer
Signalquelle 17. Das gefilterte Signal wird am Ausgang 11 des letzten RC-
Vierpoles $2_n$ abgegriffen.

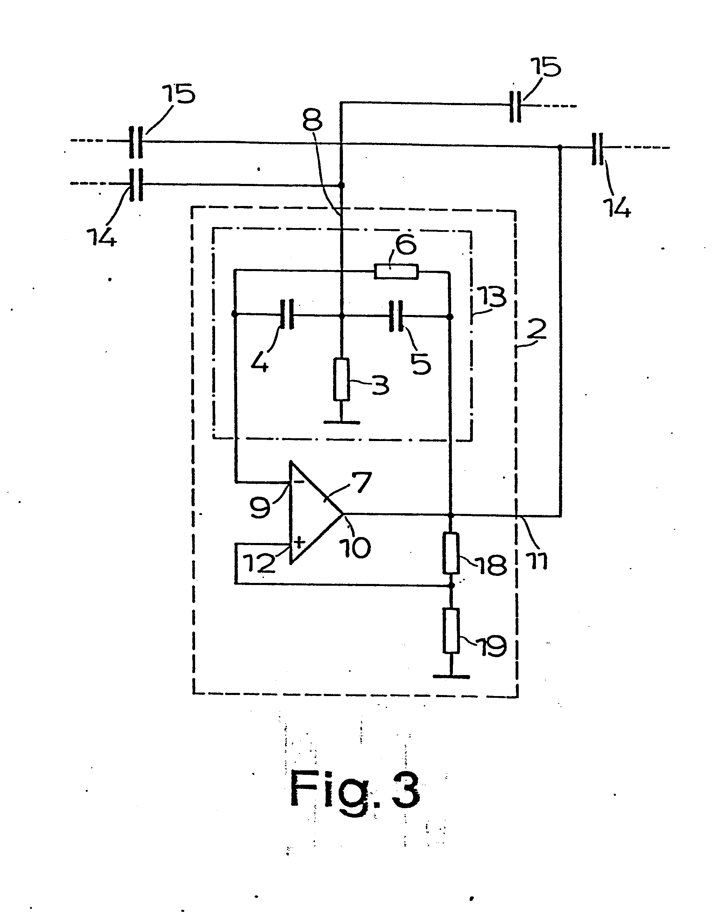

Zur Ausbildung als Bandpaßfilter können in jedem RC-Vierpol 2 die Ableitadmittanz 3 und die Rückführadmittanz 6 jeweils als ohm'scher Widerstand
und die Filteradmittanzen 4, 5 als Kondensatoren realisiert sein. Dann
aber müssen die Kopplungsadmittanzen 14, 15 ebenfalls als Kondensatoren
realisiert sein. Ein entsprechendes Ausführungsbeispiel eines RC-Vierpoles 2
zur Realisierung eines Bandpaßfilters zeigt Fig. 3. Der in Fig. 3 dargestellte RC-Vierpol 2 hat noch insoweit eine Besonderheit, als der nichtinvertierende Eingang 12 des Verstärkers 7 über eine erste Abstimmadmittanz 18
mit dem Ausgang 10 des Verstärkers 7 und über eine zweite Abstimmadmittanz 19
mit Masse verbunden ist. Abstimmadmittanzen 18, 19 sind hier als ohm'sche
Widerstände realisiert. Diese Schaltungsanordnung gilt für alle "inneren"
RC-Vierpole $2_m$ und erlaubt die Realisierung eines RC-Koppelfilters 1 in
Form eines reell abgeschlossenen Reaktanz-Vierpoles.

Bei einem derartigen RC-Koppelfilter 1 lassen sich die inneren Dämpfungen
der einzelnen RC-Vierpole $2_m$ durch Einstellung der Abstimmadmittanzen 18,
19 praktisch vernachlässigbar klein machen.

Die Koppelfaktoren $k_{m,m+1}$ stellen sich als Quotienten gleichartiger Elemente dar und sind daher sehr stabil gegenüber Variationen der Elemente.
Im vorliegenden Fall gilt beispielsweise für $k_{m,m+1}$:

$$k_{m,m+1} = \frac{C_{m,m+1}}{C} = \frac{C_{m,m+1}}{\sqrt{C_{m5} \cdot C_{(m+1)5}}}$$

Dabei ist $C_{m,m+1}$ die Kapazität des als Kopplungsadmittanz dienenen Kondensators zwischen dem m-ten RC-Vierpol $2_m$ und dem (m+1)-ten RC-Vierpol $2_{m+1}$
und $C_{m5}$ bzw. $C_{(m+1)5}$ sind die Kapazitäten der entsprechenden Filteradmittanzen $5_m$ bzw. $5_{m+1}$ zwischen dem Eingang 8 und dem Ausgang 11 des entsprechenden RC-Vierpoles $2_m$ bzw. $2_{m+1}$.

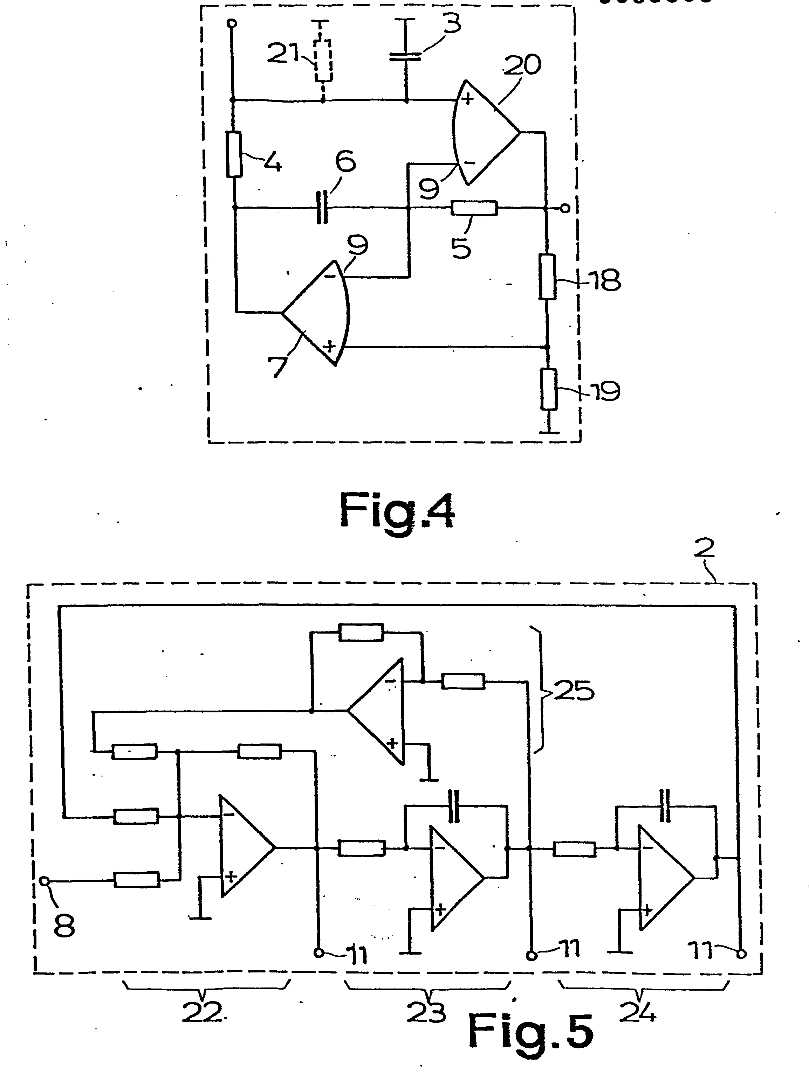

Fig. 4 zeigt das Schaltbild eines als Resonator ausgeführten RC-Vierpoles 2.
Soweit die Elemente der Schaltung den zuvor erläuterten Elementen in etwa
entsprechen, sind gleiche Bezugszeichen verwendet worden. Dieser als Resonator ausgeführte RC-Vierpol 2 weist zwei mit ihren invertierenden Eingängen 9 miteinander verbundene Verstärker 7, 20 auf. Er ist auf einfache
Weise dadurch entdämpfbar, daß man, so man dies benötigt, den Eingangswiderstand 21 wegläßt. Ist der Eingangswiderstand 21 vorhanden, so muß
dieser parallel zur Ableitadmittanz 3 an Masse gelegt werden. Lediglich
für den ersten RC-Vierpol $2_1$ liegt der Eingangswiderstand $21_1$ nicht an
Masse, da über ihn das zu filternde Signal eingespeist wird.

Fig. 5 zeigt eine Universalschaltung für einen RC-Vierpol 2 gemäß Fig. 1, die mehrstufig ausgeführt ist, nämlich eine Summierstufe 22, zwei Integrierstufen 23, 24 und eine Invertierstufe 25 aufweist. Je nach dem, an welchen
der Ausgänge 11 man herangeht, können unterschiedliche Filtercharakteristika
verwirklicht werden.

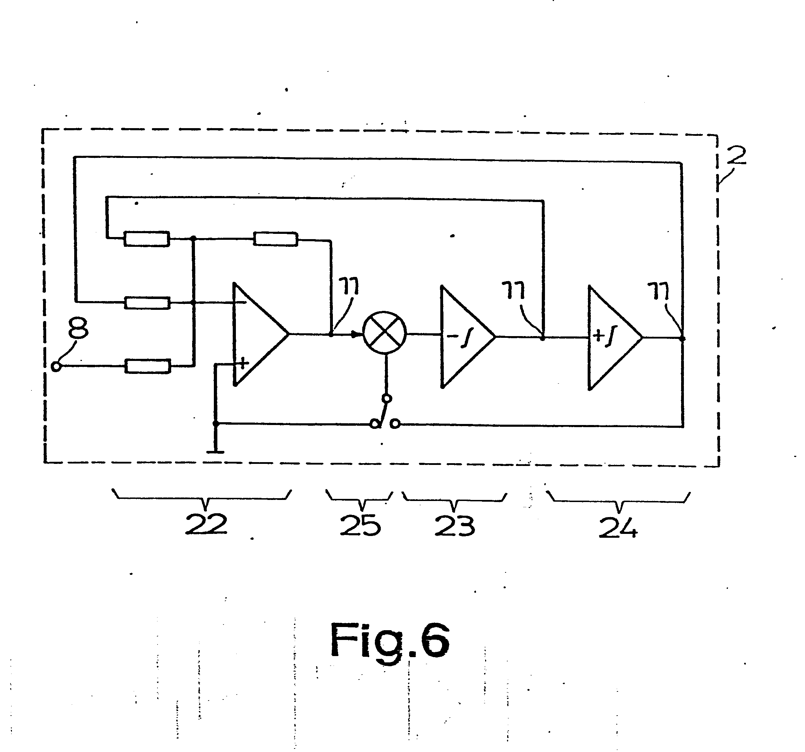

Eine spezielle Ausführungsform der Universalschaltung nach Fig. 5 zeigt
Fig. 6. Es handelt sich dabei um ein sog. Kondensatorschalterfilter, das
in CMOS-Technologie integriert werden kann.

In Fig. 7 ist ein LC-Vierpol 26 dargestellt, der in einem LC-Koppelfilter 1
Verwendung finden kann. Bei diesem LC-Vierpol 26 handelt es sich um einen
aktiven LC-Vierpol mit einer Filterinduktivität 27, einem zugehörigen Spulenwiderstand 27', einer Filterkapazität 28, einem Verstärker 29, einem
Ableitwiderstand 30, einem Filterwiderstand 31, einem ersten Abstimmwiderstand 32 und einem zweiten Abstimmwiderstand 33. Die Filterinduktivität 27
ist einerseits an den nichtinvertierenden Eingang des Verstärkers 29, andererseits an den Filterwiderstand 31 angeschlossen, während die Filterkapazität 28 einerseits an den Ausgang des Verstärkers 29, andererseits
an das andere Ende des Filterwiderstandesn 31 angeschlossen ist. Der Ableitwiderstand 30 liegt zwischen dem nichtinvertierenden Eingang des Verstärkers 29 und Masse, während der invertierende Eingang des Verstäkers 29
über den ersten Abstimmwiderstand 32 mit dem Ausgang des Verstärkers 29 und
über den zweiten Abstimmwiderstand 33 mit Masse verbunden ist.

Die Kopplung benachbarter LC-Vierpole 26 erfolgt, wie Fig. 8 deutlich zeigt,
über die Filterinduktivitäten 27.

Die Einspeisung des zu filternden Signales erfolgt bei dem LC-Koppelfilter 1
gemäß Fig. 8 über eine Einspeisungsschaltung 34 über einen Einspeisungswiderstand 35 und eine Einspeisungskapazität 36 in die Filterinduktivität
$27_1$ des ersten LC-Vierpoles $26_1$. Die Auskopplung des gefilterten Signales erfolgt von der Filterkapazität $28_n$ des letzten LC-Vierpoles $26_n$ über einen Auskopplungswiderstand 37 und einen über Abgleichwiderstände 38, 39 abgeglichenen Verstärker 40.

Die Koppelfaktoren $k_{m,m+1}$ stellen sich auch hier als Quotienten gleichartiger passiver Elemente dar und sind daher sehr stabil gegenüber Variationen der Elemente. Im vorliegenden Fall gilt beispielsweise für $k_{m,m+1}$:

$$k_{m,m+1} = \frac{M_{m,m+1}}{L} = \frac{M_{m,m+1}}{\sqrt{L_m \cdot L_{m+1}}}$$

Dabei ist $M_{m,m+1}$ die Gegeninduktivität der als Kopplungselement dienenden Filterinduktivität $L_{m+1}$ zwischen dem m-ten LC-Vierpol $26_m$ und dem (m+1)-ten LC-Vierpol $26_{m+1}$ und $L_m$ bzw. $L_{m+1}$ sind die Filterinduktivitäten der entsprechenden LC-Vierpole $26_m$ bzw. $26_{m+1}$.

In der einen Teil dieser Beschreibung bildenden Anlage sind die mathematischen und physikalischen Grundlagen des erfindungsgemäßen Koppelfilters detailliert dargestellt.

Die ursprünglich eingereichten Unterlagen enthielten eine Anlage zu der vorstehenden Beschreibung, auf die der Anmelder ausdrücklich verzichtet hat.

D. KLOSE     - 9 MEI 1983

Patentansprüche:

1. Koppelfilter, insbesondere Eingangsfilter für Empfänger von Rundsteueranlagen, mit einer Mehrzahl von gleichartigen Vierpolen, wobei jeweils benachbarte Vierpole über Kopplungsadmittanzen miteinander gekoppelt sind, d a d u r c h  g e k e n n z e i c h n e t, daß als Vierpole aktive RC-Vierpole (2) vorgesehen sind, daß vorzugsweise jeder aktive RC- Vierpol (2) eine Ableitadmittanz (3), zwei Filteradmittanzen (4, 5), eine Rückführadmittanz (6) und einen Verstärker (7) aufweist, die Ableitadmittanz (3) und die Filteradmittanzen (4, 5) jeweils mit einem Ende miteinander und mit dem Eingang (8) des RC-Vierpoles (2) verbunden sind, die Rückführadmittanz (6) mit einem Ende mit dem anderen Ende der ersten Filteradmittanz (4) und dem Eingang (9) des Verstärkers (7) verbunden ist und die anderen Enden der zweiten Filteradmittanz (5) und der Rückführadmittanz (6) sowie der Ausgang (10) des Verstärkers (7) miteinander und mit dem Ausgang (11) des RC-Vierpoles (2) verbunden sind und daß bis auf den ersten RC-Vierpol ($2_1$) und den letzten RC-Vierpol ($2_n$), der Eingang (8) jedes RC-Vierpoles ($2_m$) einerseits über eine Kopplungsadmittanz ($14_{m-1}$) mit dem Ausgang (11) des vorhergehenden RC-Vierpoles ($2_{m-1}$) und andererseits über eine weitere Kopplungsadmittanz ($15_m$) mit dem Ausgang (11) des nachfolgenden RC-Vierpoles ($2_{m+1}$) verbunden ist und der Ausgang (11) jedes RC-Vierpoles ($2_m$) einerseits über eine Kopplungsadmittanz ($15_{m-1}$) mit dem Eingang (8) des vorhergehenden RC-Vierpoles ($2_{m-1}$) und andererseits über eine weitere Kopplungsadmittanz ($14_m$) mit dem Eingang (8) des nachfolgenden RC-Vierpoles ($2_{m+1}$) verbunden ist.

2. Koppelfilter nach Anspruch 1, dadurch gekennzeichnet, daß die Einspeisung des zu filternden Signales in den nichtinvertierenden Eingang (12) des Verstärkers des ersten RC-Vierpoles ($2_1$) erfolgt.

3. Koppelfilter nach Anspruch 1 oder 2, wobei zur Ausbildung als Bandpaßfilter in jedem RC-Vierpol die Ableitadmittanz und die Rückführadmittanz jeweils als ohm'scher Widerstand und die Filteradmittanzen als Kondensatoren realisiert sind, dadurch gekennzeichnet, daß die Kopplungsadmittanzen (14, 15) als Kondensatoren realisiert sind.

4. Koppelfilter nach einem der Ansprüche 1 bis 3, dadurch gekennzeichnet, daß, bis auf den ersten RC-Vierpol $(2_1)$ und den letzten RC-Vierpol $(2_n)$, der nichtinvertierende Eingang (12) des Verstärkers (7) jedes RC-Vierpoles $(2_m)$ über eine erste Abstimmadmittanz (18) mit dem Ausgang (10) des Verstärkers (7) und über eine zweite Abstimmadmittanz (19) mit Masse verbunden ist und daß die Abstimmadmittanzen (18, 19) vorzugsweise als ohm'sche Widerstände realisiert sind.

5. Koppelfilter nach einem der Ansprüche 1 bis 4, dadurch gekennzeichnet, daß jeder RC-Vierpol (2) als Resonator mit zwei mit ihren invertierenden Eingängen (9) miteinander verbundenen Verstärkern (7, 20) ausgebildet ist oder daß jeder RC-Vierpol (2) als mehrstufige Universalschaltung, vorzugsweise mit einer Summierstufe (22), zwei Integrierstufen (23, 24) und einer Invertierstufe (25), ausgebildet ist.

6. Koppelfilter nach Anspruch 5, dadurch gekennzeichnet, daß als Universalschaltung ein integriertes Kondensatorschalterfilter vorgesehen ist.

7. Koppelfilter, insbesondere Eingangsfilter für Empfänger von Rundsteueranlagen, mit einer Mehrzahl von gleichartigen Vierpolen, wobei jeweils benachbarte Vierpole über Kopplungsadmittanzen miteinander gekoppelt sind, d a d u r c h   g e k e n n z e i c h n e t, daß als Vierpole aktive LC-Vierpole (26) vorgesehen sind, daß jeder aktive LC-Vierpol (26) mindestens eine Filterinduktivität (27), eine Filterkapazität (28) und einen Verstärker (29) aufweist, daß vorzugsweise jeder LC-Vierpol (26) weiter einen Ableitwiderstand (30) und einen Filterwiderstand (31) aufweist und daß jeweils benachbarte LC-Vierpole (26) über die Filterinduktivitäten (27) induktiv miteinander gekoppelt sind.

- 2 -

8. Koppelfilter nach Anspruch 7, dadurch gekennzeichnet, daß der Ableitwiderstand (30) als bifilarer Kupferwiderstand und der Filterwiderstand (31) als Metallschichtwiderstand ausgeführt ist.

9. Koppelfilter nach Anspruch 7 oder 8, dadurch gekennzeichnet, daß der invertierende Eingang des Verstärkers (29) über einen ersten Abstimmwiderstand (32) mit dem Ausgang des Verstärkers (29) und über einen zweiten Abstimmwiderstand (33) mit Masse verbunden ist.

10. Koppelfilter nach einem der Ansprüche 7 bis 9, dadurch gekennzeichnet, daß die Einspeisung eines zu filternden Signales über die Filterinduktivität $(27_1)$ des ersten LC-Vierpoles $(26_1)$ und die Auskopplung des gefilterten Signales über die Filterkapazität $(28_n)$ des letzten LC-Vierpoles $(26_n)$ erfolgt.

**Fig.1**

Fig. 2

Fig. 3

4/7

0085830

Fig.4

Fig.5

Fig.6

Fig.7

Fig.8